# EUROPEAN PATENT APPLICATION

(11) **EP 4 439 623 A1**
(43) Date of publication of application: **02.10.2024**
(21) Application number: 23164356.0
(22) Date of filing: 27.03.2023
(51) Int. Cl.: H01J 37/20, H01J 37/28

(54) **APPARATUS FOR CONTAMINATION REDUCTION IN CHARGED PARTICLE BEAM SYSTEMS**

(71) Applicant: ASML Netherlands B.V., 5500 AH Veldhoven (NL)
(72) Inventor: LI, Yinglong, San Jose, CA 95134 (US); FU, Shao-Wei, San Jose, CA 95134 (US)
(74) Representative: ASML Netherlands B.V.

(57) **Abstract**

Systems and apparatuses may include a component of a sample holder of a charged particle system, the component comprising a body portion comprising a noble metal; a coating layer covering at least a portion of an outer surface area of the body portion, wherein the coating layer is configured to reduce particles of the noble metal from being removed from the body portion to mitigate contaminants in the charged particle system.

## Description

### FIELD

The description herein relates to the field of inspection and metrology systems, and more particularly to apparatuses for reducing contamination in charged particle beam systems.

### BACKGROUND

In manufacturing processes of integrated circuits (ICs), unfinished or finished circuit components are inspected to ensure that they are manufactured according to design and are free of defects. An inspection system utilizing an optical microscope typically has resolution down to a few hundred nanometers; and the resolution is limited by the wavelength of light. As the physical sizes of IC components continue to reduce down to sub-100 or even sub-10 nanometers, inspection systems capable of higher resolution than those utilizing optical microscopes are needed.

A charged particle (e.g., electron) beam microscope, such as a scanning electron microscope (SEM) or a transmission electron microscope (TEM), capable of resolution down to less than a nanometer, serves as a practicable tool for inspecting IC components having a feature size that is sub-100 nanometers. With a SEM, electrons of a single primary electron beam, or electrons of a plurality of primary electron beams, can be focused on locations of interest of a wafer under inspection. The primary electrons interact with the wafer and may be backscattered or may cause the wafer to emit secondary electrons. The intensity of the electron beams comprising the backscattered electrons and the secondary electrons may vary based on the properties of the internal and external structures of the wafer, and thereby may indicate whether the wafer has defects.

### SUMMARY

Embodiments of the present disclosure provide apparatuses and systems for reducing contamination in charged particle systems. In some embodiments, a component of a sample holder of a charged particle system may include a body portion comprising a noble metal; a coating layer covering at least a portion of an outer surface area of the body portion, wherein the coating layer is configured to reduce particles of the noble metal from being removed from the body portion to mitigate contaminants in the charged particle system.

In some embodiments, a component of a sample holder of a charged particle system may include a first layer comprising a noble metal; a second layer on the first layer, wherein the second layer is configured to reduce particles of the noble metal from being removed from the first layer to mitigate contaminants in the charged particle system.

In some embodiments, a sample holder configured to hold a wafer may include a plurality of components, wherein each component of the plurality of components comprises: a body portion comprising a noble metal; a coating layer covering at least a portion of an outer surface area of the body portion, wherein the coating layer is configured to reduce particles of the noble metal from being removed from the body portion to mitigate contaminants in a charged particle system.

In some embodiments, a charged particle system may include a sample holder configured to hold a wafer, wherein the sample holder comprises a plurality of components, each component of the plurality of components comprising: a body portion comprising a noble metal; a coating layer covering at least a portion of an outer surface area of the body portion, wherein the coating layer is configured to reduce particles of the noble metal from being removed from the body portion to mitigate contaminants in the charged particle system.

### BRIEF DESCRIPTION OF THE DRAWINGS

**Fig. 1** is a schematic diagram illustrating an exemplary electron beam inspection (EBI) system, consistent with embodiments of the present disclosure.
**Fig. 2A** is a schematic diagram illustrating an exemplary multi-beam system that is part of the exemplary charged particle beam inspection system of **Fig. 1****,** consistent with embodiments of the present disclosure.
**Fig. 2B** is a schematic diagram illustrating an exemplary single-beam system that is part of the exemplary charged particle beam inspection system of **Fig. 1****,** consistent with embodiments of the present disclosure.
**Fig. 3** shows an exemplary sample holder of a charged particle beam inspection system, consistent with embodiments of the present disclosure.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the disclosure. Instead, they are merely examples of apparatuses and methods consistent with aspects related to the subject matter recited in the appended claims. For example, although some embodiments are described in the context of utilizing electron beams, the disclosure is not so limited. Other types of charged particle beams may be similarly applied. Furthermore, other imaging systems may be used, such as optical imaging, photodetection, x-ray detection, extreme ultraviolet inspection, deep ultraviolet inspection, or the like, in which they generate corresponding types of images.

Electronic devices are constructed of circuits formed on a piece of silicon called a substrate. Many circuits may be formed together on the same piece of silicon and are called integrated circuits or ICs. The size of these circuits has decreased dramatically so that many more of them can fit on the substrate. For example, an IC chip in a smart phone can be as small as a thumbnail and yet may include over 2 billion transistors, the size of each transistor being less than 1/1000th the size of a human hair.

Making these extremely small ICs is a complex, time-consuming, and expensive process, often involving hundreds of individual steps. Errors in even one step have the potential to result in defects in the finished IC rendering it useless. Thus, one goal of the manufacturing process is to avoid such defects to maximize the number of functional ICs made in the process, that is, to improve the overall yield of the process.

One component of improving yield is monitoring the chip making process to ensure that it is producing a sufficient number of functional ICs. One way to monitor the process is to inspect the chip circuit structures at various stages of their formation. Inspection may be carried out using a scanning electron microscope (SEM). A SEM can be used to image these extremely small structures, in effect, taking a "picture" of the structures of the wafer. The image can be used to determine if the structure was formed properly, and also if it was formed at the proper location. If the structure is defective, then the process can be adjusted so the defect is less likely to recur. Defects may be generated during various stages of semiconductor processing. For the reason stated above, it is important to find defects accurately and efficiently as early as possible.

The working principle of a SEM is similar to a camera. A camera takes a picture by receiving and recording brightness and colors of light reflected or emitted from people or objects. A SEM takes a "picture" by receiving and recording energies or quantities of electrons reflected or emitted from the structures. Before taking such a "picture," an electron beam may be projected onto the structures, and when the electrons are reflected or emitted ("exiting") from the structures, a detector of the SEM may receive and record the energies or quantities of those electrons to generate an image. To take such a "picture," some SEMs use a single electron beam (referred to as a "single-beam SEM"), while some SEMs use multiple electron beams (referred to as a "multi-beam SEM") to take multiple "pictures" of the wafer. By using multiple electron beams, the SEM may project more electron beams onto the structures for obtaining these multiple "pictures," resulting in more electrons exiting from the structures. Accordingly, the detector may receive more exiting electrons simultaneously, and generate images of the structures of the wafer with a higher efficiency and a faster speed.

One cause of lower quality images being generated is the deflection of electron beams due to the effect of magnetic fields that may be caused by the magnetization of equipment. The deflection of electron beams due to magnetic interference may result in the generation of distorted or shifted images. Therefore, to generate higher quality images in a charged particle system, magnetic interference in the system should be reduced (e.g., minimized) or mitigated.

Charged particle systems include a sample holder (e.g., electrostatic chuck) that may hold a wafer on a stage for inspection and that may be designed to reduce or minimize magnetic interference. The sample holder includes several metal components, such as grounding pins and mounting interfaces (e.g., mounting screws). Typical sample holders include metal components made of beryllium copper (BeCu) to reduce (e.g., minimize) or mitigate magnetic interference caused by the metal components. Using components made of BeCu may mitigate magnetic interference from the components themselves due to the lower magnetism properties of BeCu.

Typical sample holder components, however, suffer from constraints. For example, when a sample is loaded onto or unloaded from the sample holder, grinding (e.g., friction between components) of the sample holder components and electrical discharge from the sample holder components (e.g., from the grounding pins) occur. This grinding and electrical discharge from the BeCu components cause beryllium and copper to be removed from the sample holder components, thereby contaminating the sample with beryllium and copper. This contamination is harmful and unwanted because beryllium is toxic and copper contamination may, for example, negatively affect production yield and image quality.

The disclosed embodiments provide systems and apparatuses that address some or all of these disadvantages by providing components that reduce contamination in charged particle systems. The disclosed embodiments may provide a component of a sample holder of a charged particle system, the component including a body portion comprising a noble metal; a coating layer covering at least a portion of an outer surface area of the body portion, wherein the coating layer is configured to reduce particles of the noble metal from being removed from the body portion to mitigate contaminants in the charged particle system.

Relative dimensions of components in drawings may be exaggerated for clarity. Within the following description of drawings, the same or like reference numbers refer to the same or like components or entities, and only the differences with respect to the individual embodiments are described.

As used herein, unless specifically stated otherwise, the term "or" encompasses all possible combinations, except where infeasible. For example, if it is stated that a component may include A or B, then, unless specifically stated otherwise or infeasible, the component may include A, or B, or A and B. As a second example, if it is stated that a component may include A, B, or C, then, unless specifically stated otherwise or infeasible, the component may include A, or B, or C, or A and B, or A and C, or B and C, or A and B and C.

Without limiting the scope of the present disclosure, some embodiments may be described in the context of providing detectors and detection methods in systems utilizing electron beams. However, the disclosure is not so limited. Other types of charged particle beams may be similarly applied. Furthermore, systems and methods for detection may be used in other imaging systems, such as optical imaging, photon detection, x-ray detection, ion detection, etc.

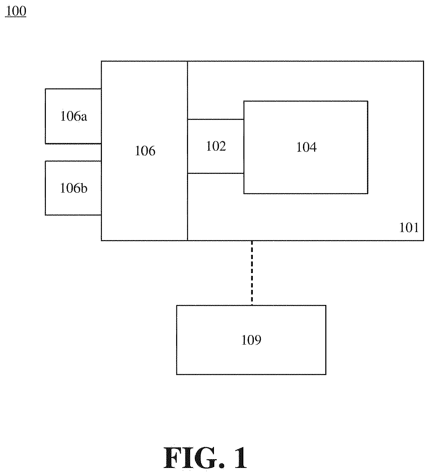

**Fig. 1** illustrates an exemplary electron beam inspection (EBI) system 100 consistent with embodiments of the present disclosure. EBI system 100 may be used for imaging. As shown in **Fig. 1****,** EBI system 100 includes a main chamber 101, a load/lock chamber 102, an electron beam tool 104, and an equipment front end module (EFEM) 106. Electron beam tool 104 is located within main chamber 101. EFEM 106 includes a first loading port 106a and a second loading port 106b. EFEM 106 may include additional loading port(s). First loading port 106a and second loading port 106b receive wafer front opening unified pods (FOUPs) that contain wafers (e.g., semiconductor wafers or wafers made of other material(s)) or samples to be inspected (wafers and samples may be used interchangeably). A "lot" is a plurality of wafers that may be loaded for processing as a batch.

One or more robotic arms (not shown) in EFEM 106 may transport the wafers to load/lock chamber 102. Load/lock chamber 102 is connected to a load/lock vacuum pump system (not shown) which removes gas molecules in load/lock chamber 102 to reach a first pressure below the atmospheric pressure. After reaching the first pressure, one or more robotic arms (not shown) may transport the wafer from load/lock chamber 102 to main chamber 101. Main chamber 101 is connected to a main chamber vacuum pump system (not shown) which removes gas molecules in main chamber 101 to reach a second pressure below the first pressure. After reaching the second pressure, the wafer is subject to inspection by electron beam tool 104. Electron beam tool 104 may be a single-beam system or a multi-beam system.

A controller 109 is electronically connected to electron beam tool 104. Controller 109 may be a computer configured to execute various controls of EBI system 100. While controller 109 is shown in **Fig. 1** as being outside of the structure that includes main chamber 101, load/lock chamber 102, and EFEM 106, it is appreciated that controller 109 may be a part of the structure.

In some embodiments, controller 109 may include one or more processors (not shown). A processor may be a generic or specific electronic device capable of manipulating or processing information. For example, the processor may include any combination of any number of a central processing unit (or "CPU"), a graphics processing unit (or "GPU"), an optical processor, a programmable logic controllers, a microcontroller, a microprocessor, a digital signal processor, an intellectual property (IP) core, a Programmable Logic Array (PLA), a Programmable Array Logic (PAL), a Generic Array Logic (GAL), a Complex Programmable Logic Device (CPLD), a Field-Programmable Gate Array (FPGA), a System On Chip (SoC), an Application-Specific Integrated Circuit (ASIC), and any type circuit capable of data processing. The processor may also be a virtual processor that includes one or more processors distributed across multiple machines or devices coupled via a network.

In some embodiments, controller 109 may further include one or more memories (not shown). A memory may be a generic or specific electronic device capable of storing codes and data accessible by the processor (e.g., via a bus). For example, the memory may include any combination of any number of a random-access memory (RAM), a read-only memory (ROM), an optical disc, a magnetic disk, a hard drive, a solid-state drive, a flash drive, a security digital (SD) card, a memory stick, a compact flash (CF) card, or any type of storage device. The codes may include an operating system (OS) and one or more application programs (or "apps") for specific tasks. The memory may also be a virtual memory that includes one or more memories distributed across multiple machines or devices coupled via a network.

Embodiments of this disclosure may provide a single charged-particle beam imaging system ("single-beam system"). Compared with a single-beam system, a multiple charged-particle beam imaging system ("multi-beam system") may be designed to optimize throughput for different scan modes. Embodiments of this disclosure provide a multi-beam system with the capability of optimizing throughput for different scan modes by using beam arrays with different geometries and adapting to different throughputs and resolution requirements.

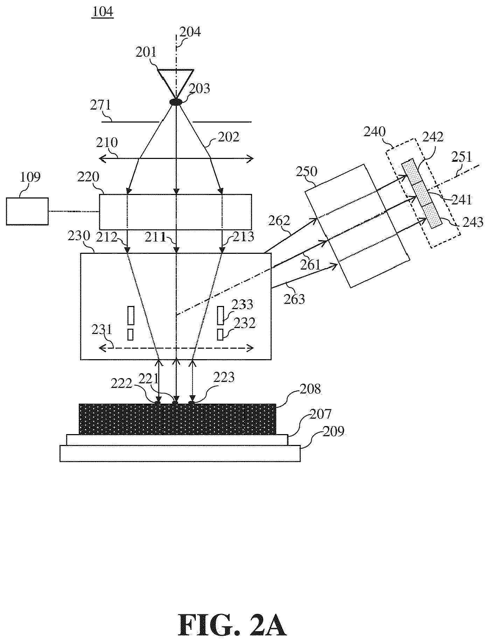

Reference is now made to **Fig. 2A****,** which is a schematic diagram illustrating an exemplary electron beam tool 104 including a multi-beam inspection tool that is part of the EBI system 100 of **Fig. 1****,** consistent with embodiments of the present disclosure. In some embodiments, electron beam tool 104 may be operated as a single-beam inspection tool that is part of EBI system 100 of **Fig. 1****.** Multi-beam electron beam tool 104 (also referred to herein as apparatus 104) comprises an electron source 201, a Coulomb aperture plate (or "gun aperture plate") 271, a condenser lens 210, a source conversion unit 220, a primary projection system 230, a motorized stage 209, and a sample holder 207 supported by motorized stage 209 to hold a sample 208 (e.g., a wafer or a photomask) to be inspected. Multi-beam electron beam tool 104 may further comprise a secondary projection system 250 and an electron detection device 240. Primary projection system 230 may comprise an objective lens 231. Electron detection device 240 may comprise a plurality of detection elements 241, 242, and 243. A beam separator 233 and a deflection scanning unit 232 may be positioned inside primary projection system 230.

Electron source 201, Coulomb aperture plate 271, condenser lens 210, source conversion unit 220, beam separator 233, deflection scanning unit 232, and primary projection system 230 may be aligned with a primary optical axis 204 of apparatus 104. Secondary projection system 250 and electron detection device 240 may be aligned with a secondary optical axis 251 of apparatus 104.

Electron source 201 may comprise a cathode (not shown) and an extractor or anode (not shown), in which, during operation, electron source 201 is configured to emit primary electrons from the cathode and the primary electrons are extracted or accelerated by the extractor and/or the anode to form a primary electron beam 202 that form a primary beam crossover (virtual or real) 203. Primary electron beam 202 may be visualized as being emitted from primary beam crossover 203.

Source conversion unit 220 may comprise an image-forming element array (not shown), an aberration compensator array (not shown), a beam-limit aperture array (not shown), and a pre-bending micro-deflector array (not shown). In some embodiments, the pre-bending micro-deflector array deflects a plurality of primary beamlets 211, 212, 213 of primary electron beam 202 to normally enter the beam-limit aperture array, the image-forming element array, and an aberration compensator array. In some embodiments, apparatus 104 may be operated as a single-beam system such that a single primary beamlet is generated. In some embodiments, condenser lens 210 is designed to focus primary electron beam 202 to become a parallel beam and be normally incident onto source conversion unit 220. The image-forming element array may comprise a plurality of micro-deflectors or micro-lenses to influence the plurality of primary beamlets 211, 212, 213 of primary electron beam 202 and to form a plurality of parallel images (virtual or real) of primary beam crossover 203, one for each of the primary beamlets 211, 212, and 213. In some embodiments, the aberration compensator array may comprise a field curvature compensator array (not shown) and an astigmatism compensator array (not shown). The field curvature compensator array may comprise a plurality of micro-lenses to compensate field curvature aberrations of the primary beamlets 211, 212, and 213. The astigmatism compensator array may comprise a plurality of micro-stigmators to compensate astigmatism aberrations of the primary beamlets 211, 212, and 213. The beam-limit aperture array may be configured to limit diameters of individual primary beamlets 211, 212, and 213. **Fig. 2A** shows three primary beamlets 211, 212, and 213 as an example, and it is appreciated that source conversion unit 220 may be configured to form any number of primary beamlets. Controller 109 may be connected to various parts of EBI system 100 of **Fig. 1****,** such as source conversion unit 220, electron detection device 240, primary projection system 230, or motorized stage 209. In some embodiments, as explained in further details below, controller 109 may perform various image and signal processing functions. Controller 109 may also generate various control signals to govern operations of the charged particle beam inspection system.

Condenser lens 210 is configured to focus primary electron beam 202. Condenser lens 210 may further be configured to adjust electric currents of primary beamlets 211, 212, and 213 downstream of source conversion unit 220 by varying the focusing power of condenser lens 210. Alternatively, the electric currents may be changed by altering the radial sizes of beam-limit apertures within the beam-limit aperture array corresponding to the individual primary beamlets. The electric currents may be changed by both altering the radial sizes of beam-limit apertures and the focusing power of condenser lens 210. Condenser lens 210 may be an adjustable condenser lens that may be configured so that the position of its first principal plane is movable. The adjustable condenser lens may be configured to be magnetic, which may result in off-axis beamlets 212 and 213 illuminating source conversion unit 220 with rotation angles. The rotation angles change with the focusing power or the position of the first principal plane of the adjustable condenser lens. Condenser lens 210 may be an anti-rotation condenser lens that may be configured to keep the rotation angles unchanged while the focusing power of condenser lens 210 is changed. In some embodiments, condenser lens 210 may be an adjustable anti-rotation condenser lens, in which the rotation angles do not change when its focusing power and the position of its first principal plane are varied.

Objective lens 231 may be configured to focus beamlets 211, 212, and 213 onto a sample 208 for inspection and may form, in the current embodiments, three probe spots 221, 222, and 223 on the surface of sample 208. Coulomb aperture plate 271, in operation, is configured to block off peripheral electrons of primary electron beam 202 to reduce Coulomb effect. The Coulomb effect may enlarge the size of each of probe spots 221, 222, and 223 of primary beamlets 211, 212, 213, and therefore deteriorate inspection resolution.

Beam separator 233 may, for example, be a Wien filter comprising an electrostatic deflector generating an electrostatic dipole field and a magnetic dipole field (not shown in **Fig. 2A**). In operation, beam separator 233 may be configured to exert an electrostatic force by electrostatic dipole field on individual electrons of primary beamlets 211, 212, and 213. The electrostatic force is equal in magnitude but opposite in direction to the magnetic force exerted by magnetic dipole field of beam separator 233 on the individual electrons. Primary beamlets 211, 212, and 213 may therefore pass at least substantially straight through beam separator 233 with at least substantially zero deflection angles.

Deflection scanning unit 232, in operation, is configured to deflect primary beamlets 211, 212, and 213 to scan probe spots 221, 222, and 223 across individual scanning areas in a section of the surface of sample 208. In response to incidence of primary beamlets 211, 212, and 213 or probe spots 221, 222, and 223 on sample 208, electrons emerge from sample 208 and generate three secondary electron beams 261, 262, and 263. Each of secondary electron beams 261, 262, and 263 typically comprise secondary electrons (having electron energy ≤ 50eV) and backscattered electrons (having electron energy between 50eV and the landing energy of primary beamlets 211, 212, and 213). Beam separator 233 is configured to deflect secondary electron beams 261, 262, and 263 towards secondary projection system 250. Secondary projection system 250 subsequently focuses secondary electron beams 261, 262, and 263 onto detection elements 241, 242, and 243 of electron detection device 240. Detection elements 241, 242, and 243 are arranged to detect corresponding secondary electron beams 261, 262, and 263 and generate corresponding signals which are sent to controller 109 or a signal processing system (not shown), e.g., to construct images of the corresponding scanned areas of sample 208.

In some embodiments, detection elements 241, 242, and 243 detect corresponding secondary electron beams 261, 262, and 263, respectively, and generate corresponding intensity signal outputs (not shown) to an image processing system (e.g., controller 109). In some embodiments, each detection element 241, 242, and 243 may comprise one or more pixels. The intensity signal output of a detection element may be a sum of signals generated by all the pixels within the detection element.

In some embodiments, controller 109 may comprise image processing system that includes an image acquirer (not shown), a storage (not shown). The image acquirer may comprise one or more processors. For example, the image acquirer may comprise a computer, server, mainframe host, terminals, personal computer, any kind of mobile computing devices, and the like, or a combination thereof. The image acquirer may be communicatively coupled to electron detection device 240 of apparatus 104 through a medium such as an electrical conductor, optical fiber cable, portable storage media, IR, Bluetooth, internet, wireless network, wireless radio, among others, or a combination thereof. In some embodiments, the image acquirer may receive a signal from electron detection device 240 and may construct an image. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. In some embodiments, the storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

In some embodiments, the image acquirer may acquire one or more images of a sample based on an imaging signal received from electron detection device 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time sequence. The multiple images may be stored in the storage. In some embodiments, controller 109 may be configured to perform image processing steps with the multiple images of the same location of sample 208.

In some embodiments, controller 109 may include measurement circuitries (e.g., analog-to-digital converters) to obtain a distribution of the detected secondary electrons. The electron distribution data collected during a detection time window, in combination with corresponding scan path data of each of primary beamlets 211, 212, and 213 incident on the wafer surface, can be used to reconstruct images of the wafer structures under inspection. The reconstructed images can be used to reveal various features of the internal or external structures of sample 208, and thereby can be used to reveal any defects that may exist in the wafer.

In some embodiments, controller 109 may control motorized stage 209 to move sample 208 during inspection of sample 208. In some embodiments, controller 109 may enable motorized stage 209 to move sample 208 in a direction continuously at a constant speed. In other embodiments, controller 109 may enable motorized stage 209 to change the speed of the movement of sample 208 over time depending on the steps of scanning process.

Although **Fig. 2A** shows that apparatus 104 uses three primary electron beams, it is appreciated that apparatus 104 may use one, two, or more number of primary electron beams. The present disclosure does not limit the number of primary electron beams used in apparatus 104. In some embodiments, apparatus 104 may be a SEM used for lithography. In some embodiments, electron beam tool 104 may be a single-beam system or a multi-beam system.

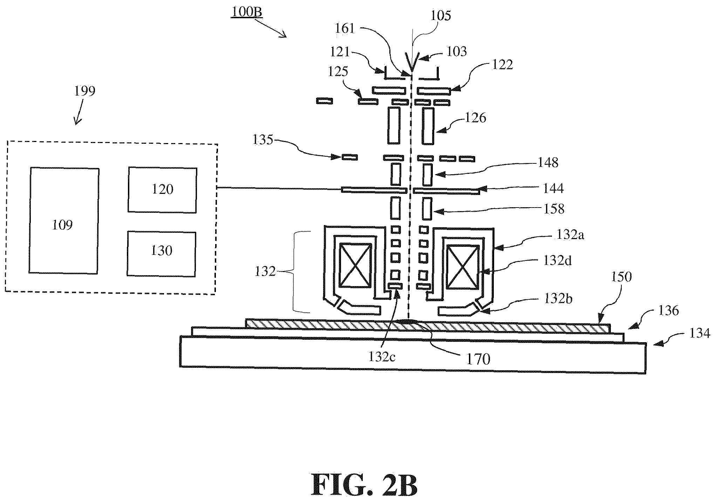

For example, as shown in **Fig. 2B****,** an electron beam tool 100B (also referred to herein as apparatus 100B) may be a single-beam inspection tool that is used in EBI system 10, consistent with embodiments of the present disclosure. Apparatus 100B includes a wafer holder 136 supported by motorized stage 134 to hold a wafer 150 to be inspected. Electron beam tool 100B includes an electron emitter, which may comprise a cathode 103, an anode 121, and a gun aperture 122. Electron beam tool 100B further includes a beam limit aperture 125, a condenser lens 126, a column aperture 135, an objective lens assembly 132, and a detector 144. Objective lens assembly 132, in some embodiments, may be a modified SORIL lens, which includes a pole piece 132a, a control electrode 132b, a deflector 132c, and an exciting coil 132d. In an imaging process, an electron beam 161 emanating from the tip of cathode 103 may be accelerated by anode 121 voltage, pass through gun aperture 122, beam limit aperture 125, condenser lens 126, and be focused into a probe spot 170 by the modified SORIL lens and impinge onto the surface of wafer 150. Probe spot 170 may be scanned across the surface of wafer 150 by a deflector, such as deflector 132c or other deflectors in the SORIL lens. Secondary or scattered primary particles, such as secondary electrons or scattered primary electrons emanated from the wafer surface may be collected by detector 144 to determine intensity of the beam and so that an image of an area of interest on wafer 150 may be reconstructed.

There may also be provided an image processing system 199 that includes an image acquirer 120, a storage 130, and controller 109. Image acquirer 120 may comprise one or more processors. For example, image acquirer 120 may comprise a computer, server, mainframe host, terminals, personal computer, any kind of mobile computing devices, and the like, or a combination thereof. Image acquirer 120 may connect with detector 144 of electron beam tool 100B through a medium such as an electrical conductor, optical fiber cable, portable storage media, IR, Bluetooth, internet, wireless network, wireless radio, or a combination thereof. Image acquirer 120 may receive a signal from detector 144 and may construct an image. Image acquirer 120 may thus acquire images of wafer 150. Image acquirer 120 may also perform various post-processing functions, such as generating contours, superimposing indicators on an acquired image, and the like. Image acquirer 120 may be configured to perform adjustments of brightness and contrast, etc. of acquired images. Storage 130 may be a storage medium such as a hard disk, random access memory (RAM), cloud storage, other types of computer readable memory, and the like. Storage 130 may be coupled with image acquirer 120 and may be used for saving scanned raw image data as original images, and post-processed images. Image acquirer 120 and storage 130 may be connected to controller 109. In some embodiments, image acquirer 120, storage 130, and controller 109 may be integrated together as one electronic control unit.

In some embodiments, image acquirer 120 may acquire one or more images of a sample based on an imaging signal received from detector 144. An imaging signal may correspond to a scanning operation for conducting charged particle imaging. An acquired image may be a single image comprising a plurality of imaging areas that may contain various features of wafer 150. The single image may be stored in storage 130. Imaging may be performed on the basis of imaging frames.

The condenser and illumination optics of the electron beam tool may comprise or be supplemented by electromagnetic quadrupole electron lenses. For example, as shown in Fig. 2B, electron beam tool 100B may comprise a first quadrupole lens 148 and a second quadrupole lens 158. In some embodiments, the quadrupole lenses are used for controlling the electron beam. For example, first quadrupole lens 148 can be controlled to adjust the beam current and second quadrupole lens 158 can be controlled to adjust the beam spot size and beam shape.

**Fig. 2B** illustrates a charged particle beam apparatus in which an inspection system may use a single primary beam that may be configured to generate secondary electrons by interacting with wafer 150. Detector 144 may be placed along optical axis 105, as in the embodiment shown in **Fig. 2B****.** The primary electron beam may be configured to travel along optical axis 105. Accordingly, detector 144 may include a hole at its center so that the primary electron beam may pass through to reach wafer 150.

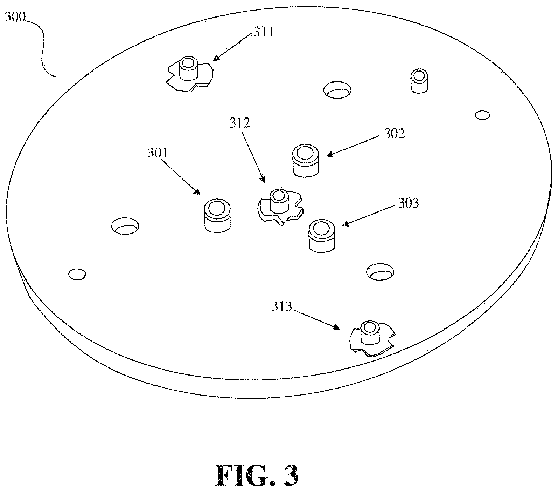

Reference is now made to **Fig. 3**, an exemplary sample holder 300 (e.g., sample holder 207 of **Fig. 2A****,** wafer holder 136 of **Fig. 2B**) of a charged particle beam inspection system, consistent with embodiments of the present disclosure. In some embodiments, sample holder 300 may be supported by a stage (e.g., motorized stage 209 of **Fig. 2A****,** motorized stage 134 of **Fig. 2B**) and may hold a sample (e.g., sample 208 of **Fig. 2A****,** wafer 150 of **Fig. 2B**) during inspection of the sample. In some embodiments, sample holder 300 may include a plurality of components, including grounding pins 301, 302, and 303 and mounting pins 311, 312, and 313.

In some embodiments, each component (e.g., grounding pins 301, 302, 303 and mounting pins 311, 312, 313) of sample holder 300 may include a body portion including a noble metal (e.g., copper). For example, each component may be made of beryllium copper (BeCu). Advantageously, the components of sample holder 300 may mitigate magnetic interference from the components themselves due to the lower magnetism properties of BeCu.

In some embodiments, the BeCu body portion of each component may include a coating layer (e.g., a protective layer) covering at least a portion of its outer surface area. The coating layer may uniformly coat at least a portion of the outer surface area of the BeCu body portion of each component and have higher adhesion to the BeCu body portion. In some embodiments, the coating layer may include non-magnetic materials (e.g., aluminum, titanium) to further reduce or mitigate magnetic interferences caused by the components. For example, some magnetic materials (e.g., nickel) may not be desirable for the coating layer due to it causing an increase in magnetic interference from the components. In some embodiments, the coating layer may include non-noble metals (e.g., chromium). In some embodiments, the coating layer may include materials that exhibit a certain range of characteristics (e.g., materials with a relative magnetic permeability of less than 1.05). In some embodiments, the coating layer may coat the entire outer surface area of the outer surface area.

In some embodiments, the coating layer may be a thin protective layer (e.g., approximately 5 µm) to further reduce and mitigate magnetic interferences caused by the components since magnetic interference is directly proportional to the volume of the material of the component. However, it should be understood that the components of sample holder 300 are not limited to having a thinner coating layer and there is no upper limit to the thickness of the coating layer.

In some embodiments, due to the coating layer covering at least a portion of an outer surface area of the body portion of each component and having at least some of the properties described above, the coating layer may be configured to reduce a number of particles of the noble metal (e.g., copper) from being removed from the body portion (e.g., made of BeCu) to mitigate contaminants in the charged particle system.

For example, when a sample is loaded onto or unloaded from sample holder 300, grinding (e.g., friction between components) of the components of sample holder 300 and electrical discharge from the components of sample holder 300 (e.g., from grounding pins 301, 302, 303 or mounting pins 311, 312, 313) may occur. The coating layer coating each component of sample holder 300 reduces the number of beryllium and copper particles that are removed from the components during grinding and electrical discharge, thereby reducing and mitigating contamination of the sample in sample holder 300 with beryllium and copper.

The embodiments may further be described using the following clauses:
1. A component of a sample holder of a charged particle system, the component comprising:
   a body portion comprising a noble metal;
   a coating layer covering at least a portion of an outer surface area of the body portion,
   wherein the coating layer is configured to reduce particles of the noble metal from being removed from the body portion to mitigate contaminants in the charged particle system.
2. The component of clause 1, wherein the coating layer is uniformly coated on the at least a portion of the outer surface area of the body portion.
3. The component of any one of clauses 1-2, wherein the noble metal comprises copper.
4. The component of any one of clauses 1-3, wherein the body portion comprises BeCu.
5. The component of any one of clauses 1-4, wherein the coating layer comprises a non-magnetic material.
6. The component of any one of clauses 1-5, wherein the coating layer comprises a non-noble metal.
7. The component of any one of clauses 1-6, wherein the coating layer at least one of aluminum, titanium, or chromium.
8. The component of any one of clauses 1-7, wherein the coating layer has a thickness of less than 5 µm.
9. The component of any one of clauses 1-8, wherein the component is a grounding pin or a mounting pin.
10. A component of a sample holder of a charged particle system, the component comprising:
   a first layer comprising a noble metal;
   a second layer on the first layer,
   wherein the second layer is configured to reduce particles of the noble metal from being removed from the first layer to mitigate contaminants in the charged particle system.
11. The component of clause 10, wherein the second layer is uniformly coated on the first layer.
12. The component of any one of clauses 10-11, wherein the noble metal comprises copper.
13. The component of any one of clauses 10-12, wherein the first layer comprises BeCu.
14. The component of any one of clauses 10-13, wherein the second layer comprises a non-magnetic material.
15. The component of any one of clauses 10-14, wherein the second layer comprises a non-noble metal.
16. The component of any one of clauses 10-15, wherein the second layer at least one of aluminum, titanium, or chromium.
17. The component of any one of clauses 10-16, wherein the second layer has a thickness of less than 5 µm.
18. The component of any one of clauses 10-17, wherein the component is a grounding pin or a mounting pin.
19. A sample holder configured to hold a wafer, the sample holder comprising:
   a plurality of components, wherein each component of the plurality of components comprises:
   a body portion comprising a noble metal;
   a coating layer covering at least a portion of an outer surface area of the body portion,
   wherein the coating layer is configured to reduce particles of the noble metal from being removed from the body portion to mitigate contaminants in a charged particle system.
20. The sample holder of clause 19, wherein the coating layer is uniformly coated on the at least a portion of the outer surface area of the body portion.
21. The sample holder of any one of clauses 19-20, wherein the noble metal comprises copper.
22. The sample holder of any one of clauses 19-21, wherein the body portion comprises BeCu.
23. The sample holder of any one of clauses 19-22, wherein the coating layer comprises a non-magnetic material.
24. The sample holder of any one of clauses 19-23, wherein the coating layer comprises a non-noble metal.
25. The sample holder of any one of clauses 19-24, wherein the coating layer at least one of aluminum, titanium, or chromium.
26. The sample holder of any one of clauses 19-25, wherein the coating layer has a thickness of less than 5 µm.
27. The sample holder of any one of clauses 19-26, wherein the component is a grounding pin or a mounting pin.
28. A charged particle system comprising:
   a sample holder configured to hold a wafer,
   wherein the sample holder comprises a plurality of components, each component of the plurality of components comprising:
      a body portion comprising a noble metal;
      a coating layer covering at least a portion of an outer surface area of the body portion,
      wherein the coating layer is configured to reduce particles of the noble metal from being removed from the body portion to mitigate contaminants in the charged particle system.
29. The charged particle system of clause 28, wherein the coating layer is uniformly coated on the at least a portion of the outer surface area of the body portion.
30. The charged particle system of any one of clauses 28-29, wherein the noble metal comprises copper.
31. The charged particle system of any one of clauses 28-30, wherein the body portion comprises BeCu.
32. The charged particle system of any one of clauses 28-31, wherein the coating layer comprises a non-magnetic material.
33. The charged particle system of any one of clauses 28-32, wherein the coating layer comprises a non-noble metal.
34. The charged particle system of any one of clauses 28-33, wherein the coating layer at least one of aluminum, titanium, or chromium.
35. The charged particle system of any one of clauses 28-34, wherein the coating layer has a thickness of less than 5 µm.
36. The charged particle system of any one of clauses 28-35, wherein the component is a grounding pin or a mounting pin.

It will be appreciated that the embodiments of the present disclosure are not limited to the exact construction that has been described above and illustrated in the accompanying drawings, and that various modifications and changes may be made without departing from the scope thereof.

## Claims

1. A component of a sample holder of a charged particle system, the component comprising:
a body portion comprising a noble metal;
a coating layer covering at least a portion of an outer surface area of the body portion,
wherein the coating layer is configured to reduce particles of the noble metal from being removed from the body portion to mitigate contaminants in the charged particle system.

2. The component of claim 1, wherein the coating layer is uniformly coated on the at least a portion of the outer surface area of the body portion.

3. The component of any one of claims 1-2, wherein the coating layer comprises a non-magnetic material.

4. The component of any one of claims 1-3, wherein the coating layer comprises a non-noble metal.

5. The component of any one of claims 1-4, wherein the coating layer at least one of aluminum, titanium, or chromium.

6. The component of any one of claims 1-5, wherein the coating layer has a thickness of less than 5 µm.

7. The component of any one of claims 1-6, wherein the component is a grounding pin or a mounting pin.

8. A component of a sample holder of a charged particle system, the component comprising:
a first layer comprising a noble metal;
a second layer on the first layer,
wherein the second layer is configured to reduce particles of the noble metal from being removed from the first layer to mitigate contaminants in the charged particle system.

9. A sample holder configured to hold a wafer, the sample holder comprising:
a plurality of components, wherein each component of the plurality of components comprises:
a body portion comprising a noble metal;
a coating layer covering at least a portion of an outer surface area of the body portion,
wherein the coating layer is configured to reduce particles of the noble metal from being removed from the body portion to mitigate contaminants in a charged particle system.

10. The sample holder of claim 9, wherein the coating layer is uniformly coated on the at least a portion of the outer surface area of the body portion.

11. The sample holder of any one of claims 9-10, wherein the coating layer comprises a non-magnetic material.

12. The sample holder of any one of claims 9-11, wherein the coating layer comprises a non-noble metal.

13. The sample holder of any one of claims 9-12, wherein the coating layer at least one of aluminum, titanium, or chromium.

14. The sample holder of any one of claims 9-13, wherein the coating layer has a thickness of less than 5 µm.

15. A charged particle system comprising:
a sample holder configured to hold a wafer,
wherein the sample holder comprises a plurality of components, each component of the plurality of components comprising:
a body portion comprising a noble metal;
a coating layer covering at least a portion of an outer surface area of the body portion,
wherein the coating layer is configured to reduce particles of the noble metal from being removed from the body portion to mitigate contaminants in the charged particle system.
